# EUROPÄISCHE PATENTSCHRIFT

(11) **EP 2 576 855 B1**
(45) Veröffentlichungstag und Bekanntmachung des Hinweises auf die Patenterteilung: **02.03.2016**
(21) Anmeldenummer: 11721506.1
(22) Anmeldetag: 19.05.2011
(51) Int. Cl.: C23C 14/54

(54) **VERFAHREN UND VORRICHTUNG ZUM AUFBRINGEN VON FESTSTOFFSCHICHTEN**
PROCESS AND APPARATUS FOR THE APPLICATION OF SOLID LAYERS
PROCÉDÉ ET DISPOSITIF D'APPLICATION DE COUCHES DE MATIÈRE SOLIDE

(30) Priorität: 25.05.2010 DE 102010021444
(43) Veröffentlichungstag der Anmeldung: 10.04.2013
(73) Patentinhaber: Max-Planck-Gesellschaft zur Förderung der Wissenschaften e.V., 80539 München (DE)
(72) Erfinder: FISCHER, Dieter, 71272 Renningen (DE); JANSEN, Martin, D-53127 Bonn (DE); DE LA FUENTE LEIS, Xermán, F., E-50018 Zaragoza (ES)
(74) Vertreter: Hannke, Christian
(86) Internationale Anmeldenummer: PCT/EP2011/058101
(87) Internationale Veröffentlichungsnummer: WO 2011/147730

(56) Entgegenhaltungen:
- EP-A1- 0 770 700
- WO-A2-00/44822
- JP-A- 6 279 180
- JP-A- 6 293 958
- JP-A- 2005 171 269
- US-A1- 2004 110 042
- US-A1- 2007 129 255

## Beschreibung

Die Erfindung betrifft ein Verfahren und eine Vorrichtung zum Aufbringen von Feststoffschichten auf ein zu beschichtendes Objekt mittels mindestens einer Strahlungserzeugungsquelle, insbesondere einer Laserstrahlerzeugungsquelle, umfassend den Schritt des Abtragens einer Probe, welche verschiedene Materialabschnitte aufweist, mit einem von der Strahlungserzeugungsquelle emittierten Strahl zum Überführen des Materials der Probenoberfläche aus eines festem Zustand in einen gasförmigen Zustand, auch Gasphase genannt, der sich auf einem zu beschichtenden Objekt als dünner Film abscheidet.

Bei der Herstellung von Beschichtungen insbesondere von Schutzschichten gegen Korrosion Materialverschleiß, optischen Vergütungen sowie supraleitenden oder ferromagnetischen Funktionsschichten oder auch in der Mess- und Regelungstechnik ist es notwendig, dass Schichten entsprechend ihrer Funktion dünn, im Bereich von mehreren Nanometern bis Mikrometern, ausgestaltet sind. Herkömmlicherweise werden derartige Schichten mittels Laserstrahlverdampfen bereitgestellt. Bei dieser Technik wird das zu übertragende Material in der Regel in Form einer scheibenartigen Probe vorgelegt. Unter Verwendung von hochenergetischen Pulslasern wird das Material der Probenoberfläche aus dem festen Zustand in den gasförmigen Zustand überführt und gleichzeitig gerichtet beschleunigt, so dass sich die entstandene gasförmige Wolke aus abgetragenem Material der Probenoberfläche auf einem nahen Objekt als dünne Feststoffschicht abscheidet. Allerdings neigen Materialpartikel in der Gasphase zu Agglomeration. Scheiden sich diese Agglomerate auf dem zu beschichtenden Objekt ab, wird die Qualität der abgeschiedenen Feststoffschicht dahin gehend verschlechtert, dass keine gleichmäßig dicke Feststoffschicht ausgebildet wird, was jedoch für den Einsatz der Feststoffschichten unter anderem in der Steuer- und Regelungstechnik zur korrekten Weiterleitung elektronischer Signale unerlässlich ist.

Gewöhnlich werden mit dem Laserstrahlverdampfen lediglich kleine und schmale Flächen im Rahmen weniger Quadratzentimeter beschichtet. Häufig erfolgt dabei die Abtragung der Oberfläche der Probe unter Rotation der Probe oder Auslenkung der Probe in x/y *-* Richtung, wobei der Verlauf des emittierten Strahles zeitgleich stationär angeordnet ist. Wie aus dem Stand der Technik bekannt, ist das herkömmliche Verfahren des Laserstrahlverdampfens von zahlreichen Prozessparametern, wie beispielsweise von der Energie des emittierten Strahles, der Pulsfolge, der Abtragungsgeschwindigkeit des Probenmaterials, der Materialzusammensetzung der Probe oder der Anordnung des zu beschichtenden Objektes in Bezug auf die Ausrichtung der Probe, abhängig.

Des Weiteren werden für das Abscheiden von verschiedenen Materialien mehrere separate Proben benutzt, welche nebeneinander in einem sogenannten Probenwechsler integrierbar angeordnet sind, wobei der Probenwechsel die einzelnen Proben nacheinander in Strahlposition führt. Dies bedingt einen aufwendigen Beschichtungsprozess, bei dem lediglich immer nur eine Materialzusammensetzung durch den Strahl abgetragen und als neue Beschichtung abgeschieden wird.

Die US 2005/0067389 A1 beschreibt ein zweistufiges Verfahren zum Laserstrahlverdampfen, wobei der Laserstrahl zunächst einem festgelegten Pfad in x/y - Richtung folgt, diesen vervollständigt und erst in einem zweiten Schritt die Probe um einen festen Winkel rotiert wird. Diese Abfolge ertolgt periodisch und ermöglicht die Erosion der Probe zu reduzieren. Durch diese gleichbleibende, sich wiederholende Schrittabfolge wird durch den fixierten Rotationswinkel immer ein Bereich der Probe unabgetragen bleiben, was zu Abschattungseffekten führt. Unter Abschattungseffekten wird allgemein die durch überstehendes Festmaterial in Form von Kanten eingeschränkte Ausbreitung des gasförmigen Zustandes der abgetragenen Probe verstanden. Zudem wird die Wahrscheinlichkeit der Bildung von Materialbruchfragmenten aus der Oberfläche der Probe, insbesonders von Materialbruchfragmenten der überstehenden Kanten, welche sich als Ganzes auf dem zu beschichtenden Objekt abscheiden, erhöht. Diese Materialbruchfragmente, deren Größe sich bis in den Millimeterbereich erstrecken kann, aus der Oberfläche der Probe bedingen starke Schwankungen in der Schichtdicke der Feststoffschicht. Für den Einsatz der mit der Feststoffschicht beschichteten Objekte ist es jedoch notwendig, dass die Feststoffschicht dünn, bevorzugt mit einer Schichtdicke im Nanometer- oder Mikrometerbereich, und gleichmäßig, d.h. dass die abgeschiedene Feststoffschicht auf dem zu beschichtenden Objekt an jeder Position eine vergleichbare Schichtdicke aufweist, ausgebildet ist.

US2007/0129255 A1 offenbart ein Verfahren zur Abscheidung von Feststoffschichten mittles gepulstem Laserverdampfen.

Ausgehend von dem bekannten Stand der Technik liegt der Erfindung die Aufgabe zugrunde, ein Verfahren und eine Vorrichtung zum Aufbringen von Feststoffschichten auf ein zu beschichtendes Objekt zur Verfügung zu stellen, welche eine gleichmäßige, materialunabhängige Abtragung der Probenoberfläche, welche aus verschiedenen Materialabschnitten besteht, unter Reduzierung der Bildung von unerwünschten Materialbruchfragmenten aus der Oberfläche der Probe ermöglichen und mit welchen ebenfalls eine gleichmäßige Beschichtung ohne Schichtdickendifferenzen von großflächigen Objekten im Quadratmeterbereich realisiert werden kann.

Erfindungsgemäß wird diese Aufgabe verfahrensseitig durch zeitgleiche Bewegung einer Probe und Veränderung des Verlaufes des emittierten Strahles in seiner Ausrichtung während des Schrittes der Abtragung gemäß den Merkmalen des Anspruches 1 sowie vorrichtungsseitig gemäß den Merkmalen des Anspruches 8 gelöst.

Gemäß einer bevorzugten Ausführungsform erfolgt die Veränderungsbewegung der Ausrichtung des Verlaufes des emittierten Strahles abhängig von der Bewegung der Probe, wobei die Probe den Verlauf des emittierten Strahles kreuzt. Im Fall der Abhängigkeit sind die Veränderungsbewegung, welche die Ausrichtung des Verlaufes des emittierten Strahles bedingt, und die Bewegung der Probe miteinander durch ihre Bewegungsgeschwindigkeit gekoppelt. So ist denkbar, dass bei einer scheibenartig ausgebildeten Probe, deren Bewegung in einer Rotation um eine zentrale Achse der Probe besteht, eine Zunahme der Rotationsgeschwindigkeit eine Erniedrigung der Geschwindigkeit der Veränderungsbewegung des Verlaufes des emittierten Strahles bedingt. Als zentrale Achse der Probe ist hierbei die Achse festgelegt, welche senkrecht zu der Oberfläche der Probe durch den Mittelpunkt der Oberfläche der Probe verläuft. Darüber hinaus kann eine Zunahme (Abnahme) der Bewegungsgeschwindigkeit der Probe ebenfalls eine Zunahme (Abnahme) der Geschwindigkeit der Veränderungsbewegung des Verlaufes des emittierten Strahles bedingen.

Vorteilhaft werden die Veränderungsbewegung des Verlaufes des emittierten Strahles in seiner Ausrichtung und die Bewegung der Probe mittels Computersteuerung kontrolliert und überwacht.

Gemäß einer weiteren bevorzugten Ausführungsform erfolgt die Veränderung des Strahlverlaufes in seiner Ausrichtung derart, dass sich eine Linearbewegung des Strahles an der Oberfläche der Probe, die den Verlauf des emittierten Strahles kreuzt, ergibt. Die Linearbewegung des Strahles an der Oberfläche der Probe kann beispielsweise horizontal, vertikal oder in einer Kombination aus beiden Richtungen erfolgen, wobei die Veränderungsrichtung des Verlaufes des emittierten Strahles in seiner Ausrichtung in Bezug auf den ursprünglichen, unausgelenkten Strahl zu beziehen ist. Hierbei kann beispielsweise die Linearbewegung des Strahles an einer Oberfläche einer scheibenartig ausgebildeten Probe durch den Mittelpunkt der Oberfläche der Probe führen. Ist die Probe hingegen in einer rechteckigen Geometrie ausgestaltet, so erfolgt die Linearbewegung bevorzugt über die gesamte Oberfläche der Probe. Zudem kann die Veränderungsbewegung des emittierten Strahles in seiner Ausrichtung durch Mittel zur Strahlablenkung eine kreiskegelartige Form beschreiben, welche auf der Oberfläche der Probe als rotierender Strahl dargestellt wird.

Gemäß einer weiteren vorteilhaften Ausführungsform trifft der emittierte Strahl unter einem vorbestimmbaren Winkel auf die Oberfläche der Probe, die den Verlauf des emittierten Strahles kreuzt, wobei die Probe zeitgleich bevorzugt um eine zentrale Achse, welche senkrecht zu der Oberfläche der Probe durch den Mittelpunkt der Oberfläche der Probe verläuft, rotiert. Bei dem vorbestimmbaren Winkel des Strahles handelt es sich um denjenigen Winkel, den der emittierte Strahl beim Auftreffen auf die Probenoberfläche mit dieser einschließt.

Der vorbestimmbare Winkel wird bevorzugt so gewählt, dass die Veränderungsbewegung des Verlaufes des Strahles durch den Mittelpunkt der Oberfläche führt. Bevorzugt erfolgt die Rotation der Probe langsam im Vergleich zu der Veränderung des Verlaufes des emittierten Strahles in seiner Ausrichtung. Die Rotationsgeschwindigkeit der Probe liegt zwischen 0,1 und 250 Umdrehungen pro Minute, bevorzugt zwischen 1 und 50 Umdrehungen pro Minute.

Gemäß einer weiteren bevorzugten Ausführungsform trifft der Strahl unter einem vorbestimmbaren Winkel auf die Oberfläche der Probe, die den Verlauf des emittierten Strahles kreuzt, auf, wobei eine Position der Probe zeitgleich in eine senkrecht zum Verlauf des Strahles sich erstreckende Richtung verändert wird. Diese Positionsänderung der Probe kann sowohl vertikal als auch horizontal oder in einer Kombination aus beiden Bewegungen erfolgen. Die Geschwindigkeit der Bewegung der Positionsänderung der Probe erfolgt bevorzugt langsam im Vergleich zu der Veränderungsbewegung des Verlaufes des emittierten Strahles, wobei bevorzugte Geschwindigkeiten sich im Rahmen zwischen 0,01 und 50 µm / Sekunde bewegen.

Gemäß einer weiteren bevorzugten Ausführungsform erweist es sich als vorteilhaft, wenn die Probe aus verschiedenen Abschnitten zusammengesetzt ist, welche bevorzugt aus unterschiedlichen Materialien bestehen. Ist die Probe beispielsweise scheibenartig mit kuchenstückartigen Abschnitten der Probe ausgebildet, welche unterschiedlich in der Materialzusammensetzung sind, kann unter gleichzeitiger Rotation der Probe um ihre zentrale Achse und der Veränderung des Verlaufes des emittierten Strahles in seiner Ausrichtung eine periodische Materialkonzentrationsabfolge der abgeschiedenen Feststoffschicht auf dem zu beschichtenden Objekt erzielt werden. Die Zusammensetzung einer einzelnen Lage der abgeschiedenen Feststoffschicht entspricht im einfachsten Beispielfall der Zusammensetzung eines Abschnittes der Probe bzw. für komplexere Fälle sind beliebige Variationen der Schichtzusammensetzungen durch die Wahl der abzutragenden Materialabschnitte bedingt. Die Summe aller abgeschiedenen Lagen bildet die Feststoffschicht. Die Periodizität der abgeschiedenen Lagen der Feststoffschicht wird bevorzugt durch die Geschwindigkeit der Probenbewegung und der Bewegung des Verlaufes des emittierten Strahles in seiner Auslenkung bestimmt. Zudem wirkt sich die Länge des Weges, den der abgelenkte Strahl während der Abtragung auf der Oberfläche der Probe beschreibt, auf die Zusammensetzung und die Dicke der einzelnen Lagen der abgeschiedenen Feststoffschicht aus. Erfolgt beispielsweise bei Rotation einer scheibenartigen Probe, welche in kuchenstückartige Abschnitte mit unterschiedlicher Materialzusammensetzung unterteilt ist, die Auslenkung des emittierten Strahles derart, dass der Strahl während der Abtragung wiederholt den gesamten Durchmesser der Oberfläche der Probe durch den Mittelpunkt der Oberfläche der Probe durchläuft, wird entsprechend mehr Material in den gasförmigen Zustand überführt, als wenn die Auslenkung des Strahles wiederholt lediglich radial vom Mittelpunkt der Oberfläche der Probe nach außen zum Umfang der Probe erfolgt. Die gasförmige Materialwolke weist somit bei der Auslenkung des Strahles über den gesamten Durchmesser der Probe eine höhere Materialkonzentration auf, als wenn die Abtragung lediglich radial erfolgt, und bedingt dadurch auch die Dicke der abgeschiedenen Feststoffschicht auf dem zu beschichtenden Objekt. Je mehr Material in der gasförmigen Wolke vorhanden ist, desto dicker werden die abgeschiedenen Lagen der Feststoffschicht auf dem zu beschichtenden Objekt ausgebildet und umgekehrt. Ferner ist es auch denkbar, dass eine Änderung der Strahlleistung Einfluss auf die Dicke der Lagen der Feststoffschicht nimmt, da durch höhere Strahlleistung auch eine stärkere Abtragung des Materials an der Oberfläche der Probe erfolgt.

Vorzugsweise werden bei der Materialzusammensetzung für die einzelnen Abschnitte der Probe chemisch homogene Elemente, insbesondere Reinelemente metallischer Natur, wie beispielsweise Titan, Silber, Aluminium oder Eisen und/oder nicht metallischer Natur, wie beispielsweise Bor, Kohlenstoff oder Phosphor, metallische Zusammensetzungen, wie Legierungen, und/oder nicht - metallische oder auch nicht - oxidische Zusammensetzungen, wie beispielsweise Karbide, Halogenide oder Nitride verwendet, wobei besagte nicht - metallische Zusammensetzungen im großtechnischen Bereich bevorzugt als Schutzschichten gegenüber Oberflächen- und Grenzflächenoxidation Anwendung finden. Darüber hinaus wäre es denkbar, keramische Verbundwerkstoffe als Materialien für die Abschnitte der Probe einzusetzen. Diese keramischen Verbundwerkstoffe zeichnen sich durch Flexibilität aus, welche durch den zusätzlich verarbeiteten Kunststoffanteil im keramischen Verbundwerkstoff bedingt wird. Bei der Verwendung des keramischen Verbundwerkstoffes als Materials für Abschnitte der Probe lässt sich somit beispielsweise die Bildung von Materialbruchfragmenten aus der Oberfläche der Probe vermeiden. Bevorzugt wird der organische Anteil des keramischen Verbundwerkstoffes, hier der flexible Kunststoffanteil, während der Abtragung der Oberfläche der Probe zersetzt, wohingegen der keramische Anteil des keramischen Verbundwerkstoffes durch die Abtragung der Oberfläche der Probe in die Gasphase überführt wird und sich als Feststoffschicht auf dem zu beschichtenden Objekt abscheidet. Werden in den Abschnitten der Probe unterschiedliche Materialzusammensetzungen vorgelegt, d.h. weist das Material der Abschnitte der Probe unterschiedliche Bestandteile, wie beispielsweise Metalle, Chalkogenide oder Halogenide, auf, trägt der emittierte Strahl die Oberfläche der Probe und somit gleichzeitig auch die Oberfläche der Abschnitte der Probe ab, wodurch sich die unterschiedlichen Materialzusammensetzungen der Abschnitte der Probe bevorzugt zeitgleich im gasförmigen Zustand befinden. Ist eine scheibenartige Probe beispielsweise in zwei Abschnitte der Probe unterteilt, wobei sich die Zusammensetzungen der Abschnitte voneinander unterscheiden und die Abschnitte der Probe einen Halbkreis beschreiben, und beschreibt diese Probe eine Rotationsbewegung um ihre zentrale Achse unter zeitgleicher horizontaler Veränderungsbewegung des Verlaufes des emittierten Strahles in seiner Ausrichtung über den gesamten Durchmesser der Probe, werden die Oberflächen beider Abschnitte kontinuierlich abgetragen und in den gasförmige Zustand überführt. Die gasförmige Wolke umfasst somit beide Materialzusammensetzungen der abgetragenen Abschnitte der Probe. Handelt es sich bei den Materialzusammensetzungen der Abschnitte der Probe in der gasförmigen Materialwolke um unreaktive chemische Verbindungen, werden die Materialzusammensetzungen der beiden abgetragenen Abschnitte der Probe auf dem zu beschichtenden Objekt als Feststoffschicht abgeschieden, das heißt, dass die abgeschiedene Feststoffschicht beide Materialzusammensetzungen der beiden Abschnitte der Probe umfasst. Handelt es sich bei den Materialzusammensetzungen der Abschnitte der Probe in der gasförmigen Materialwolke um reaktive chemische Verbindungen, können diese zumindest teilweise miteinander reagieren und neue chemische Bindungen untereinander bilden. Die abgeschiedene Feststoffschicht kann somit zusätzlich zu den Materialzusammensetzungen der beiden abgetragenen Abschnitte der Probe auch die neu gebildete chemische Verbindung aus beiden Materialzusammensetzungen umfassen. Die Zusammensetzung der Materialien in den abgeschiedenen Schichten ist durch den Weg des Strahlverlaufes über die Oberfläche der Abschnitte der Probe einstellbar und variierbar, wodurch beispielsweise Konzentrationsgradienten innerhalb einer Schicht und/oder zwischen mindestens zwei direkt zueinander benachbart angeordneten Schichten erzeugbar sind.

Gemäß einer bevorzugten Ausführungsform sind die verschiedenen Abschnitte der Probe in Form von Schichten und/oder nebeneinander auf der Oberfläche der Probe liegenden Bereichen dargestellt. Besagte Schichten können beispielsweise als aufeinanderfolgende Schichten parallel zu der Oberfläche der Probe ausgebildet sein, wobei bevorzugt jede Schicht eine Materialzusammensetzung aufweist, welche zu den Materialzusammensetzungen der benachbarten Schichten verschieden ist. Ferner ist auch denkbar, dass die Abschnitte der Probe, welche unterschiedliche Materialzusammensetzungen aufweisen, direkt an der Oberfläche der Probe benachbart angeordnet sind Die geometrische Ausbildung der Abschnitte kann beliebig erfolgen, beispielsweise kuchenstückartig, kreisartig oder auch eckig. Bevorzugt sind die Abschnitte der Probe auch im Volumen der Probe durchgängig angeordnet. So kann beispielsweise ein Abschnitt der Probe gleichzeitig mit einer ersten Abschnittsfläche zumindest einen Teil der Oberfläche der Probe und mit einer zweiten, der ersten Abschnittsfläche gegenüberliegenden, Abschnittsfläche einen Teil der Unterseite der Probe darstellen.

Gemäß einer bevorzugten Ausführungsform erfolgt während des Abtragungsschrittes senkrecht zur Oberfläche der Probe eine Bewegung der verschiedenen Abschnitte der Probe, bevorzugt einzeln. Aufgrund der Strahlleistung können Materialzusammensetzungen der Abschnitte mit unterschiedlichen chemischen und physikalischen Eigenschaften unterschiedlich schnell abgetragen werden. So entsteht ein Aufrauen der Oberfläche der Probe, welches zu Kanten- oder Stufenbildung des Materials der Oberfläche der Probe an den Grenzflächen zwischen zwei benachbarten Abschnitten der Probe führt, wodurch Abschattungseffekte bedingt werden. Durch die selektive Bewegung der Abschnitte der Probe senkrecht zur Oberfläche der Probe, bevorzugt einzeln, wird eine derartige Kanten- oder Stufenbildung des Materials an den Grenzflächen vermieden, was gleichzeitig eine Reduzierung der Bildung von möglichen Materialbruchfragmenten aus den Kanten oder Stufen heraus während des Abtragens der Oberfläche der Probe bedingt. Die Steuerung der Auslenkung der Abschnitte der Probe erfolgt durch mindestens ein Regelmittel, welches bevorzugt einen Linearantrieb steuert.

Die vorliegende Erfindung umfasst auch eine Vorrichtung zum Aufbringen von Feststoffschichten auf ein zu beschichtendes Objekt mit einer Strahlungserzeugungsquelle, insbesondere einer Laserstrahlerzeugungsquelle, einer Ausrichtungsveränderungseinrichtung zur Veränderung des Laufes des emittierten Strahles und einer Vakuumkammer, mit einer darin anordbaren Probe, welche verschiedene Abschnitte unterschiedlicher Materialien aufweist, mittels einer ersten externen Antriebseinrichtung bewegbar und mit dem Strahl in ihrer Oberfläche abtragbar ist, wobei der Strahlverlauf in seiner Ausrichtung bewegbar ist und zeitgleich die Probe bewegbar ist. Die erfindungsgemäße Vorrichtung weist eine Ausrichtungsveränderungseinrichtung zur Veränderung des Verlaufes des emittierten Strahles auf, die zumindest einen Spiegel, bevorzugt einen Galvanometerspiegel, welcher einachsig, bevorzugt aber zweiachsig ausgebildet ist, und/oder zumindest einen Strahlaufweiter, bevorzugt ein Prisma zur Vergrößerung des Durchmessers des emittierten Strahles für eine großflächige Abtragung der Oberfläche der Probe, und /oder mindestens eine Fokussiereinrichtung, bevorzugt eine Linse, mit deren Hilfe die Form des Querschnittes des Strahles veränderbar ist, aufweist. Der Strahlquerschnitt kann beispielsweise neben einem runden Querschnitt auch eckig, bevorzugt quadratisch, ausgebildet sein, um so eine gleichmäßige Abtragung der Oberfläche der Probe zu gewährleisten, wenn die Probengeometrie beispielsweise ebenfalls eckig ausgebildet ist. Bevorzugt ist denkbar, den Querschnitt des Strahles eines dreidimensionalen Laserscanners derart zu verändern, dass auch komplexe Probenformen gleichmäßig abgetragen und Agglomeratbildung in der Gasphase des überführten abgetragenen Materials der Probe sowie Materialbruchfragmentbildung aus der Oberfläche der Probe vermieden werden. Zudem ermöglicht der dreidimensionale Laserscanner die Einstellung eines konstant gehaltenen Strahlfokus über die gesamte Probenoberfläche.

Gemäß einer bevorzugten Ausführungsform sind die verschiedenen Abschnitte der Probe als Schichten und/oder als nebeneinander liegende Bereiche, welche sich in ihrer Materialzusammensetzung unterscheiden, angeordnet. Somit können gleichzeitig mehrere Materialien bereitgestellt werden. Erfolgt die Anordnung der Abschnitte der Probe in Schichten, welche parallel zu der Oberfläche der Probe sind, kann somit nach Abtragung einer oberen ersten Schicht, eine darunterliegende zweite Schicht mit einer anderen Materialzusammensetzung auf das zu beschichtende Objekt übertragen werden, ohne dass die Probe zeitaufwendig ausgetauscht werden muss.

Vorzugsweise erfolgt die geometrische Ausgestaltung der Probe in Form eines dreidimensionalen Körpers. Dies kann beispielsweise in runder Grundform, wie beispielsweise als Scheibe oder als Zylinder erfolgen, aber auch in polygonaler Geometrie, wie beispielsweise quadratisch, rechteckig oder dreieckig, erfolgen. Bevorzugt ist der Durchmesser, also die Größe der Oberfläche der Probe, nicht nur auf die gängigen Laborgrößen von wenigen Zentimetern begrenzt. Es werden bevorzugt Proben mit großem Durchmesser im Bereich von 1 bis 15 cm eingesetzt, wobei die geometrische Ausgestaltung der Probe beliebig erfolgt. Zudem ist es ferner denkbar, dass es sich bei dem dreidimensionalen Probenkörper um ein Band mit eckigem Querschnitt oder um einen Draht mit beispielsweise rundem Querschnitt handelt, welcher als Endloskörper geführt wird, um so großflächige Objekte zu beschichten ohne dabei in regelmäßigen Abständen, wie beispielsweise nach kompletter Abtragung des Probenmaterials einer scheibenartigen Probe, das Verfahren zu unterbrechen, um die verbrauchte Probe zu ersetzen und die Vakuumkammer neu zu evakuieren.

Gemäß einer bevorzugten Ausführungsform verfügt die Erfindung über ein zu beschichtendes Objekt, welches mittels einer zweiten Antriebseinrichtung bewegbar angeordnet ist. Die Bewegung des zu beschichtenden Objektes kann während der Abscheidung des gasförmigen Zustandes sowohl vertikal als auch horizontal oder in einer Kombination aus beiden Bewegungen in Bezug auf die Oberfläche der Probe erfolgen. Ferner ist denkbar, dass das zu beschichtende Objekt während der Abscheidung des gasförmigen Zustandes um eine Achse rotierbar angeordnet ist, wobei diese Achse senkrecht zu der Fläche, auf welcher sich der gasförmige Zustand abscheidet, angeordnet ist und bevorzugt durch deren Flächenmittelpunkt führt. Darüber hinaus kann das zu beschichtende Objekt, bevorzugt gleichzeitig, mit der zweiten externen Antriebseinrichtung derart ausgelenkt werden, dass der Abstand zwischen der Oberfläche der Probe und zu beschichtendem Objekt veränderbar ist. Durch diese Bewegung des zu beschichtenden Objektes wird in der vorliegenden Erfindung bevorzugt die Dicke der abgeschiedenen Feststoffschicht sowie die gleichmäßige Abscheidung des gasförmigen Zustandes des abgetragenen Probenmaterials auf flächenmäßig großen zu beschichtenden Objekten kontrolliert, ohne dabei die Strahlparameter, wie beispielsweise Strahlenergie oder Strahldurchmesser, zu verändern. Bevorzugt erfolgt die Bewegung des zu beschichtenden Objektes zeitgleich mit der Bewegung der Probe und der Veränderung des Verlaufes des emittierten Strahles. Dies ermöglicht eine schnelle Abtragung der Probenoberfläche sowie die Beschichtung von Objekten im Größenrahmen von mehreren Quadratmetern. Ferner kann das zu beschichtende Objekt plattenartig, als dreidimensionaler Körper oder auch als eine Art Endlosband ausgebildet sein.

Bei einer weiteren bevorzugten Ausführungsform ist zwischen der Probe und dem zu beschichtenden Objekt eine Maske angeordnet. Diese kann stationär gegenüber dem zu beschichtenden Objekt an einem Trägerelement angeordnet sein. Bevorzugt ist die Maske schwenkbar angeordnet, so dass sie in ihrer Position veränderbar ist. Das Schwenken erfolgt bevorzugt um eine Achse, welche senkrecht zu der horizontalen Oberfläche der Maske verläuft, wobei der Achsverlauf beliebig erfolgen kann. Bevorzugt verfügt die Maske über zumindest eine Öffnung, welche ermöglicht, dass der gasförmige Zustand der Probe auf dem zu beschichtenden Objekt in geometrischer Form der Öffnung abgeschieden wird. Ferner ist denkbar, dass die Maske mehrere Öffnungen aufweist, welche in unterschiedlicher geometrischer Ausgestaltung ausgebildet sind. Darüber hinaus ist auch denkbar, dass die Maske durch Führungssysteme, beispielsweise in Form von Schienen, in ihrer Position gegenüber dem zu beschichtenden Objekt veränderbar angeordnet ist.

Die als Strahlungserzeugungsquelle in der vorliegenden Erfindung bezeichnete Einrichtung kann sowohl eine Laserstrahlerzeugungsquelle die bevorzugt einen gepulsten Laserstrahl und besonders bevorzugt einen femtosekundengepulsten Laserstrahl erzeugt, eine energiereiche Elektronen- oder Neutronenstrahlungserzeugungsquelle oder eine Plasmaerzeugungsquelle umfassen.

Darüber hinaus ist auch denkbar, dass nicht nur ein Strahl zur Abtragung der Probenoberfläche verwendet wird. Dies kann beispielsweise durch mehrere Strahlungserzeugungsquellen, die in ihrem Verlauf veränderbare Strahlung emittieren, oder durch Strahlteiler erfolgen, welche den ursprünglich emittierten Strahl in zumindest zwei Teilstrahlen aufspalten. Beispielhaft können so vier Strahlen mit variierbarem Querschnitt in Bezug auf Form und Größe, welche alle einzeln durch Ausrichtungsveränderungseinrichtungen ablenkbar und somit in ihrem Verlauf bewegbar sind, vier Abschnitte einer Probe, welche sich in Form und/oder Materialzusammensetzung voneinander unterscheiden, gleichzeitig abtragen. Somit erfolgt einerseits eine Zeitersparnis und andererseits eine Kontrolle der Zusammensetzung der abgeschiedenen Feststoffschicht.

Im Folgenden wird die Erfindung anhand eines bevorzugten Ausführungsbeispieles im Zusammenhang mit der anhängenden Zeichnung näher erläutert. Die Zeichnung zeigt in:
- Fig. 1: eine Schnittansicht der erfindungsgemäßen Vorrichtung;
- Fig. 2: einen Ausschnitt der Schnittansicht der erfindungsgemäßen Vorrichtung aus Fig. 1;
- Fig. 3: eine schematische Ansicht der Laserbewegung;
- Fig. 4: eine weitere mögliche Bewegung des Lasers und der Probe im vorliegenden erfindungsgemäßen Verfahren;
- Fig. 5a: eine Schnittansicht der bewegbaren Abschnitte der Probe;
- Fig. 5b: eine weitere Schnittansicht der bewegbaren Abschnitte der Probe;
- Fig. 6a - 6d: Beispiele für eine geometrische Gestaltung der Probe;
- Fig. 7a - 7c: Beispiele für schematische Feststoffschichten;
- Fig. 8a - 8b: ein schematischer Querschnitt; und
- Fig. 8c: eine schematische Aufsicht auf großflächige Probenoberflächen.

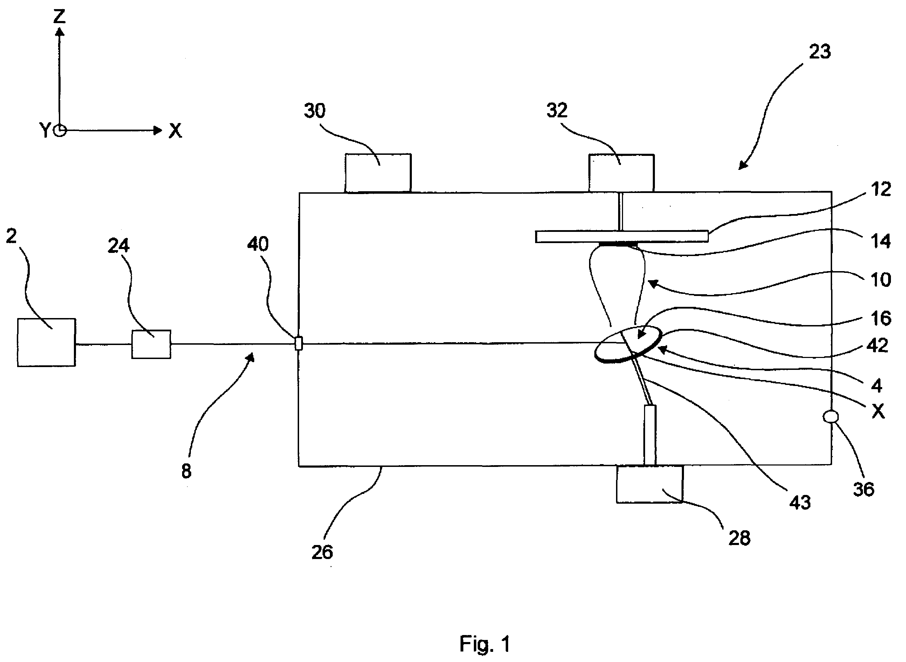

Fig. 1 zeigt ein Beispiel einer erfindungsgemäßen Ausführungsform der Vorrichtung 23. Die Strahlungserzeugungsquelle 2, welche außerhalb der Vakuumkammer 26 angeordnet ist, kann beispielsweise eine Laserstrahlerzeugungsquelle darstellen, wobei bevorzugt ein gepulster Femtolaserstrahl emittiert wird. Im Strahlverlauf des emittierten Strahles 8 in x - Richtung ist eine Ausrichtungsveränderungseinrichtung 24 bevorzugt außerhalb der Vakuumkammer 26 angeordnet. Diese Ausrichtungsveränderungseinrichtung 24 verfügt bevorzugt über zumindest einen Spiegel, insbesondere über einen zweiachsigen Galvanometerspiegel, zur Ablenkung des emittierten Strahles 8, zumindest einer Einrichtung zum Fokussieren und/oder Defokussieren sowie einer Einrichtung zum Teilen des Strahles 8 (nicht dargestellt). Im weiteren Verlauf in x - Richtung passiert der Strahl 8 zumindest ein optisches Fenster 40 der Vakuumkammer 26, in welcher ein Unterdruckt, bevorzugt ein Vakuum, herrscht, welches mittels einer Pumpeinrichtung 30 erzeugt und gehalten wird. In der Vakuumkammer 26 ist zudem eine Probe 4, welche bevorzugt aus unterschiedlichen Abschnitten 6 besteht (nicht gezeigt), austauschbar an einem Probenträger 42 angeordnet. Der Probenträger 42 ist über einen Probenträgerhalter 43 mit einer ersten externen Antriebseinrichtung 28 über ein Führungsmittel, über welches die räumliche Neigung der Probe 4 einstellbar ist, verbunden. Ferner ist in der Vakuumkammer 26 ein zu beschichtendes Objekt 12 angeordnet, welches über eine zweite externe Antriebseinrichtung 32 aus seiner Position derart auslenkbar ist, dass eine Bewegung des zu beschichtenden Objektes 12 bevorzugt linear, beispielsweise horizontal oder vertikal in Bezug auf die Probe 4 erfolgt. Zudem ist auch der Abstand zwischen der Oberfläche 16 Probe 4 und dem zu beschichtenden Objekt 12 mittels einer zweiten externen Antriebseinrichtung 32 in z - Richtung veränderbar einstellbar. Der Strahl 8 trifft auf die Oberfläche 16 der Probe 4 und führt das feste Probenmaterial in den gasförmigen Zustand 10, hier als gasförmige Materialwolke dargestellt, über. Während der Abtragung der Oberfläche 16 der Probe 4 erfolgt eine zeitgleiche Bewegung der Probe 4 und eine Veränderungsbewegung des Verlaufes des emittierten Strahles 8 in seiner Ausrichtung. Wie hier in Fig. 1 beispielhaft dargestellt ist die Probe 4 als runde Scheibe ausgebildet, welche während der Abtragung um ihre zentrale Achse, welche senkrecht zu der Oberfläche 16 der Probe 4 ausgebildet ist und durch den Mittelpunkt Z der Oberfläche 16 der Probe 4 führt, rotiert. Gleichzeitig wird der Verlauf des emittierten Strahles in seiner Ausrichtung linear horizontal in Bezug auf den ursprünglichen Strahlverlauf verändert, das heißt, dass der Strahl 8 von seinem ursprünglichen Strahlverlauf in x - Richtung in die xy - Ebene abgelenkt wird, und beschreibt auf der Oberfläche 16 der Probe 4 einen Bewegungspfad X des Strahles 8. Die Länge dieser Bewegungspfades X entspricht bevorzugt dem Durchmesser der Probe 4 und verläuft bevorzugt bei einer rotierenden, scheibenartigen Probe 4 durch deren Mittelpunkt Z der Oberfläche 16 der Probe 4. Die Abtragung der Oberfläche 16 der Probe 4 erfolgt hochenergetisch, das heißt, dass Feststoffteilchen bei dem Übergang in den gasförmigen Zustand 10 der Probe 4 eine Beschleunigung erfahren und sich auf dem zu beschichtenden Objekt 12 als Feststoffschicht 14 abscheiden. Die Feststoffschicht 14 kann beispielsweise als atomare Monolage, mehrere mikrometerdicke Schicht oder auch als Multischicht, bestehend aus mehreren Lagen, welche sich in ihrer Materialzusammensetzung voneinander unterscheiden, vorliegen. Ferner kann bei extrem kurzen Abtragungszeiten eines Abschnittes 6 der Probe 4 eine lokal begrenzte Abscheidung der gasförmigen Materialzusammensetzung 10 auf dem zu beschichtenden Objekt 12 bevorzugt in Form von Inseln erfolgen. Dies kann beispielsweise genutzt werden, um stufenförmige Feststoffschichten 14 zu erzeugen, welche in ihrer Gesamtheit jedoch weiterhin gleichmäßig dünn hinsichtlich ihrer Dicke ausgebildet sind.

Ferner wird die räumliche Ausrichtung der Probe 4 während der Abtragung der Oberfläche 16 der Probe 4 durch den emittierten Strahl 8 bevorzugt in einem räumlichen Neigungswinkel verändert. Unter dem räumlichen Neigungswinkel der Probe 4 ist der Winkel zu verstehen, um den eine Achse der Probe, welche senkrecht zu der Oberfläche der Probe 4 durch den Mittelpunkt Z der Oberfläche 16 der Probe 4 verläuft, zu der z - Achse des Koordinatensystems verschieden ist. Dies bedeutet eine räumliche Neigung der Probenoberfläche 16 sowohl in der xz - als auch in der yz - Ebene. Der Probenträger 42 dient sowohl zu der Aufnahme und Fixierung der Probe 4, beispielsweise durch Verschraubung oder Spannfedern, während der Abtragung der Oberfläche 16 der Probe 4 durch den emittierten Strahl 8 und ist bevorzugt der Geometrie der Probe 4 angepasst. An der der Probe abgewandten Flächenseite des Probenträgers 42 ist ein erstes Ende eines Probenträgerhalters 43 angeordnet, der den Probenträger 42 von der ersten externen Antriebseinrichtung 28 beabstandet. Der Probenträgerhalter 43 verfügt am zweiten Ende über ein Führungsmittel, beispielsweise einem Kugelgelenk, welches in einer gegenförmigen Aussparung der ersten externen Antriebseinrichtung 28 einführbar ist. Durch dieses Führungsmittel wird eine Änderung des räumlichen Neigungswinkels der Probe ermöglicht, wobei die Ansteuerung des Führungsmittels bevorzugt elektronisch erfolgt. Ferner ist auch denkbar, dass besagtes Führungsmittel direkt zwischen Probenträger 42 und Probenträgerhalter 43 lokalisiert ist, wobei lediglich der räumliche Neigungswinkel des Probenträgers 42 und somit auch der Probe 4 veränderbar ist während der Probenträgerhalter 43 in seiner Position unausgelenkt bleibt. Das Führungsmittel kann darüber hinaus vielfältig ausgebildet sein. Bevorzugter Weise erfolgt die Änderung des räumlichen Neigungswinkels zeitgleich mit der Rotation oder Linearbewegung der Probe 4. Durch die Änderung des räumlichen Neigungswinkels der Probe 4 kann die gasförmige Materialwolke 10 auf unterschiedliche Bereiche des zu beschichtenden Objektes 12 gerichtet werden, um sich dort als gleichmäßig dicke Feststoffschicht abzuscheiden. Es ist somit nicht notwendig, dass Probe und zu beschichtendes Objekt eine vorbestimmte feste Ausrichtung zueinander einnehmen.

Die Vakuumkammer 26 verfügt über zumindest einen zusätzlichen externen Zugang 36, durch welchen beispielsweise Gas oder Gasgemische in die Vakuumkammer 26 eingeführt werden, um Feststoffschichten 14 auf dem zu beschichtenden Objekt 12 zu erzeugen. Durch das Einleitung von reaktiven Gasen, wie beispielsweise Sauerstoff, in die Vakuumkammer 26 wird zudem eine chemische Reaktion des Gases mit dem gasförmigen Zustand 10 der Probe 4 bedingt, wodurch sich zumindest teilweise neugebildete, chemische Zusammensetzungen auf dem zu beschichtenden Objekt 12 abscheiden. Um diese Reaktion noch zu verbessern bzw. zu beschleunigen, kann eine separate Aktivierung des Gases, beispielsweise durch Spaltung in seine Atome in Form eines Plasmas, erfolgen.

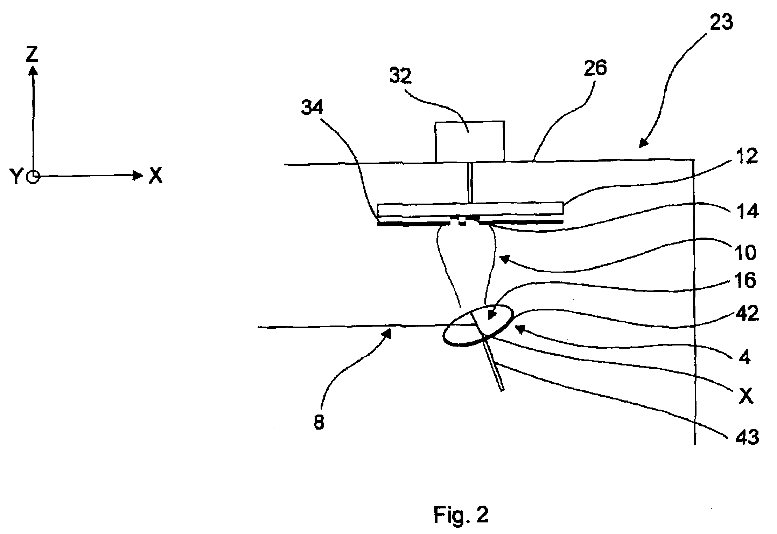

Ferner besteht die Möglichkeit, wie in Fig. 2 dargestellt, zumindest eine zusätzliche stationäre und/oder bewegbare Maske 34 anzuordnen, die über zumindest eine Öffnung 38 verfügt. Diese Öffnung 38 kann sowohl rund als auch eckig, bevorzugt als linearer Spalt, ausgebildet sein. Ferner können auch mehrere Öffnungen 38 vorgesehen sein, welche sich bevorzugt in ihrer geometrischen Ausgestaltung voneinander unterscheiden. Es ist denkbar, dass die Maske 34 schwenkbar um eine Achse, welche senkrecht zu der horizontalen Oberfläche der Maske 34 bevorzugt durch eine Ecke der Maske 34 verläuft, mit Schrauben an einem rahmenartigen System fixierbar und/oder an einem leistenartigen Führungssystem, bevorzugt in Form von Schiebeleisten, austauschbar angeordnet ist (nicht gezeigt). Dies ermöglicht eine zusätzliche lokale Abscheidung des gasförmigen Zustandes 10 der Probe 4 auf dem zu beschichtendem Objekt 12. Dies ist besonders in der Steuer- und Regelungstechnik interessant, wenn es darum geht, Schaltkreise zu generieren. Ferner ist auch denkbar, dass mehrere Masken 34 mit an unterschiedlichen Stellen vorgesehenen Öffnungen 38 bereitgestellt werden, die bevorzugt abwechselnd in den gasförmigen Zustand 10 der Probe 4 eingebracht werden, um so die Geometrie der abgeschiedenen Feststoffschichten 14 nicht nur auf einfachen Lagen oder Gradienten zu begrenzen, sondern auf komplexe Strukturen, wie beispielsweise Schaltkreise, zu erweitern.

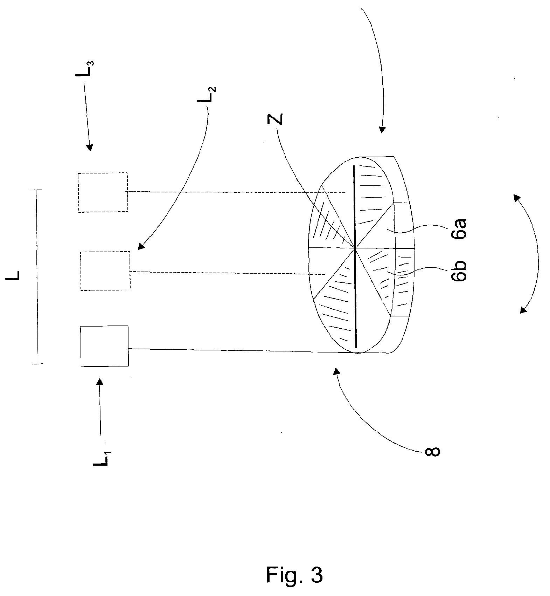

Fig. 3 zeigt eine beispielhafte schematische Darstellung der Veränderung des Verlaufes des Strahles 8 während des Schrittes der Abtragung gegenüber einer rotierbar angeordneten, scheibenartigen Probe 4 mit den unterschiedlichen kuchenstückartigen Abschnitten 6a und 6b, wobei Abschnitt 6a ein Material A aufweist, welches zu dem Material B des Abschnittes 6b unterschiedlich in der Zusammensetzung ist. Der Strahl 8 trifft in Position L1 auf die Oberfläche 16 der Probe 4 und wird linear in Richtung L über die Positionen L2 und L3 in seinem Verlauf verändert, während die Probe 4 gleichzeitig bevorzugt um eine Achse rotiert, welche auf der Probenoberfläche 16 senkrecht steht und durch den Mittelpunkt Z der Oberfläche 16 der Probe 4 führt. Diese Bewegung kann für den Fall, dass die Geschwindigkeit der Veränderung des Verlaufes des Strahles 8 sehr groß gegenüber der Geschwindigkeit der Bewegung der Probe 4 erfolgt, entlang des Bewegungspfades X des Strahles 8 an der Oberfläche 16 erfolgen. Dieser Bewegungspfad X erstreckt sich bevorzugt über den gesamten Durchmesser der Probe 4. Darüber hinaus kann der Bewegungspfad X auch beispielsweise radial bzw. entlang einer vorbestimmten Strecke auf der Oberfläche 16 der Probe 4 führen. Neben der Rotation der Probe erfolgt durch die Länge und den Weg, den der Bewegungspfad X auf der Oberfläche 16 der Probe 4 beschreibt, eine Einstellung der Zusammensetzung des gasförmigen Zustandes 10, welche auch die Zusammensetzung der abgeschiedenen Feststoffschicht 14 bedingt.

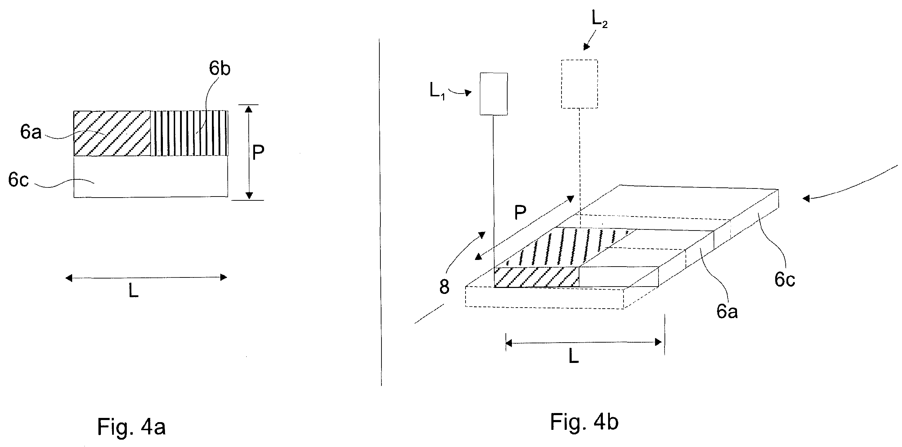

Fig. 4a zeigt die Oberfläche 16 einer polygonal ausgebildeten Probe 4, welche hier beispielsweise als Quader vorliegt, wobei die Oberfläche 16 der Probe 4 in unterschiedliche Abschnitte 6 a - c unterteilt ist. Die einzelnen Abschnitte 6a, 6b und 6c weisen unterschiedliche Materialzusammensetzungen auf, wobei bevorzugt Reinelemente und/oder Mischverbindungen vorliegen. Die Veränderung des Verlaufes des emittierten Strahles 8 ist hier schematisch dargestellt und erfolgt beispielsweise linear in horizontaler Richtung L unter gleichzeitiger Linearbewegung der Probe 4 in vertikaler Richtung P. So werden zunächst nur die beiden Abschnitte 6a und 6b abgetragen. Im weiteren Verlauf der zeitgleich stattfindenden Linearbewegungen des Strahles 8 und der Probe 4 wird Abschnitt 6c abgetragen. Die Bewegungen der Probe 4 und des Strahles 8 werden solange wiederholt, bis die Zielbeschichtung in ihrer Dicke und Zusammensetzung abgeschieden ist. In Fig. 4b ist dieser Bewegungsablauf perspektivisch dargestellt. Erfolgt die Linearbewegung der Probe 4 langsam im Vergleich zu der Veränderung des Verlaufes des Strahles 8, so erfolgt bevorzugt ein linienartiges Abtragen der Materialien. Bevorzugt erfolgt die Bewegung der Probe 4 vertikal und die Veränderungsbewegung des Verlaufes des Strahles 8 horizontal. Besonders bevorzugt bei polygonalen Probengeometrien ist der Querschnitt des Strahles 8 von rund verschieden ausgebildet. Ein beispielsweise eckig ausgeprägter Strahlquerschnitt ist vorteilhaft, da dieser durch das vorliegende Verfahren präzise justiert werden kann und das Probenmaterial gleichmäßig abträgt. Ein runder Strahlquerschnitt erfordert bei einer Linearbewegung der eckigen Probe 4 immer einen sich überschneidenden Bewegungspfad X. Vorzugsweise sind die Bewegungen der Probe 4 und des Strahles 8 derart aufeinander abgestimmt, dass kein Versatz an den Materialgrenzflächen der Abschnitte 6 bedingt wird.

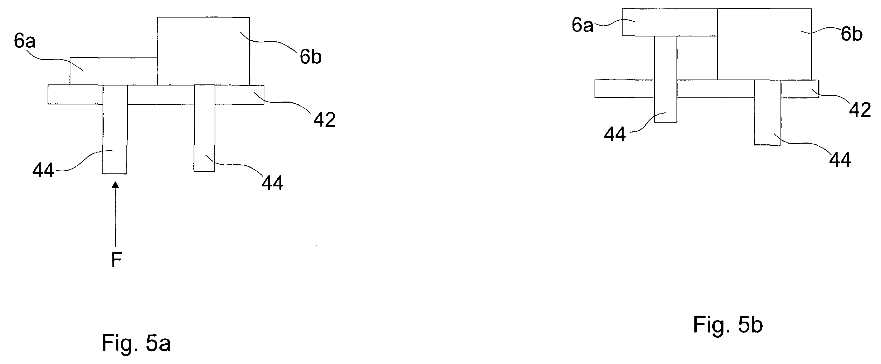

In Fig. 5a ist ein Querschnitt einer scheibenartigen Probe 4, welcher die Abschnitte 6a und 6b aufweist dargestellt. Wird als Strahlungserzeugungsquelle 2 beispielsweise ein gepulster Nanosekundenlaser verwendet, erfolgt eine materialabhängige Abtragung der Abschnitte 6a und 6b, wobei beispielsweise das Material A von Abschnitt 6a wesentlich schneller abgetragen wird als das Material B von Abschnitt 6b. Der Abschnitt 6a nimmt hierbei in seiner Dicke schneller ab als Abschnitt 6b. Die entstehenden Höhendifferenzen zwischen den Abschnitten 6a und 6b führen zu unerwünschten Abschattungseffekten, die bei kontinuierlich durchgeführten Abtragungsschritten zu einer verminderten Abscheidung der gasförmigen Phase 10 auf dem zu beschichtenden Objekt 12 führen. Daher verfügt die Vorrichtung 23 der vorliegenden Erfindung bevorzugter Weise über zumindest einen bewegbaren Stempel 44, welcher in einer Bewegungsrichtung F aus seiner Ausgangsposition auslenkbar ist und während der Auslenkung in Bewegungsrichtung F zumindest einen Abschnitt 6 der Probe 4 mit auslenkt. Bevorzugt ist der Stempel 44 gegenüber dem Probenträger 42 in seiner Position in Bewegungsrichtung F verschiebbar angeordnet, wobei die Bewegung des Stempels 44 senkrecht zu der Oberfläche 16 der Probe 4 erfolgt. Bevorzugt verfügt jeder Abschnitt 6 der Probe 4 über einen bewegbaren Stempel 44, der den Abschnitt 6 der Probe 4 an der Unterseite zumindest teilweise flächig bedeckt. Darüber hinaus ist auch denkbar, dass der bewegbare Stempel 44 lediglich punktuell die Unterseite der Abschnitte 6 der Probe 4 berührt, um diese in Bewegungsrichtung F aus ihrer Ausgangsposition senkrecht zu der Oberfläche 16 der Probe 4 anzuheben. Ferner ist denkbar, dass alle Abschnitte 6 mit gleicher Materialzusammensetzung gleichzeitig angehoben werden. Die Bewegung des Stempels 44 erfolgt bevorzugt gleichzeitig zu den beiden ebenfalls gleichzeitig ablaufenden Bewegungen der Probe 4 und der Veränderung des Verlaufes des emittierten Strahles 8 und ist bevorzugt derart gestaltet, dass das Anheben der schneller abgetragenen Abschnitte 6 der Probe 4, hier beispielhaft im Abschnitt 6a dargestellt, während der Abtragung der Oberfläche 16 der Probe 4 kontinuierlich nachgeregelt wird, so dass, wie in Fig. 5b dargestellt, zu jedem Zeitpunkt der Abtragung eine gleichmäßige Oberflächenbeschaffenheit der Probe 4 unter Auslenkung der schneller abgetragenen Abschnitte gewährleistet wird.

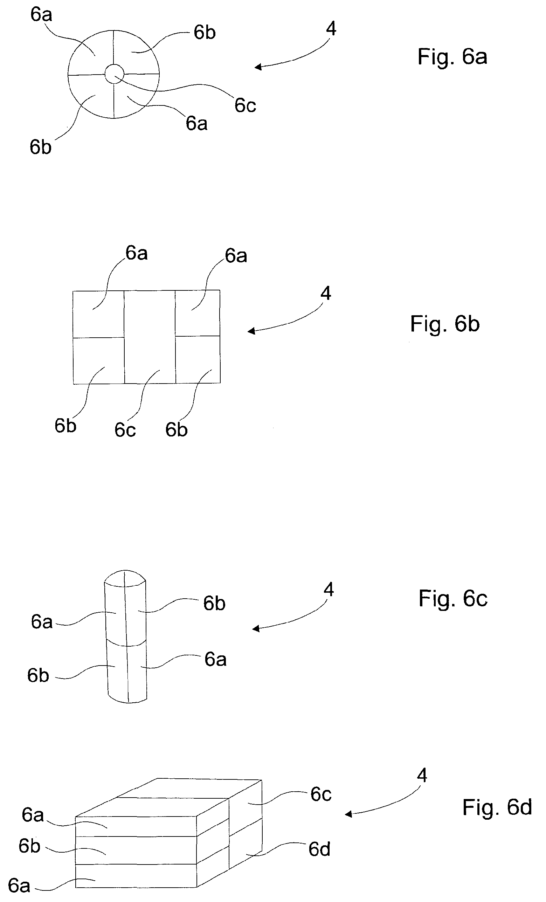

In Fig. 6 sind Beispiele für die Gestaltung der Probe 4 aufgezeigt, welche sich während des vorgestellten Verfahrens als besonders gute Basis für gleichmäßige Feststoffschichten 14 ergeben haben. In Fig. 6a ist eine runde, scheibenartige Ausgestaltung der Probe 4 dargestellt, welche drei unterschiedliche Abschnitte 6a, 6b und 6c aufweist, wobei Abschnitt 6a aus Material A, Abschnitt 6b aus Material B und Abschnitt 6c aus Material C besteht und diese Materialien zueinander verschieden in ihrer Zusammensetzung sind. Die Abschnitte 6a und 6b sind kuchenstückartig ausgebildet und sind zu dem kreisförmig ausgebildeten Abschnitt 6c benachbart. Diese Ausgestaltung dient lediglich als mögliches Beispiel einer Probengeometrie. Es ist auch denkbar, dass zahlreiche unterschiedliche Abschnitte 6 der Probe 4 nebeneinander und hintereinander an der Oberfläche 16 der Probe 4 angeordnet sind. Dies ermöglicht die Beschichtung von großflächigen Objekten 12, da sich während des Verfahrens ebenfalls das Volumen des gasförmigen Zustandes 10 durch einen erhöhten Materialabtrag aufgrund der Durchmesserzunahme der Probe 4 vergrößert. Die in Fig. 6b gezeigte beispielhafte Probe 4 weist eine eckige Geometrie und ebenfalls in der Materialzusammensetzung unterschiedliche Abschnitte 6a, 6b und 6c auf. Ferner kann beispielsweise die dreidimensionale Gestaltung der Probe 4 in Form eines Zylinders oder Stabes erfolgen, welcher in unterschiedlichen Abschnitten 6 der Probe 4, die wiederum aus unterschiedlichen Materialien bestehen, unterteilt ist (Fig. 6c). Ferner ist auch möglich, dass die Probengeometrie eckig, bevorzugt als Kubus oder Quader, ausgebildet sein kann, wobei die unterschiedlichen Abschnitte 6 der Probe 4 bevorzugt in Schichten parallel zur Oberfläche 16 und besonders bevorzugt als Bereiche senkrecht zur Oberfläche 16 der Probe 4 ausgebildet sein können und zumindest teilweise das Volumen der Probe durchdringen (Fig. 6d). Ferner sind auch spiralförmige Anordnungen der Abschnitte 6 sowohl in Volumen als auch an der Oberfläche 14 denkbar (nicht gezeigt). Werden darüber hinaus großflächige Proben 4 verwendet, so ist es vorteilhaft einen Strahlteiler einzusetzen, der den emittierten Strahl 8 derart aufspaltet, dass an mehreren Positionen der Probe 4 gleichzeitig eine Materialabtragung erfolgt. So ermöglicht die vorliegende Erfindung eine gleichmäßige und schnelle Abscheidung von Feststoffschichten 14 auf großflächigen Objekten 12.

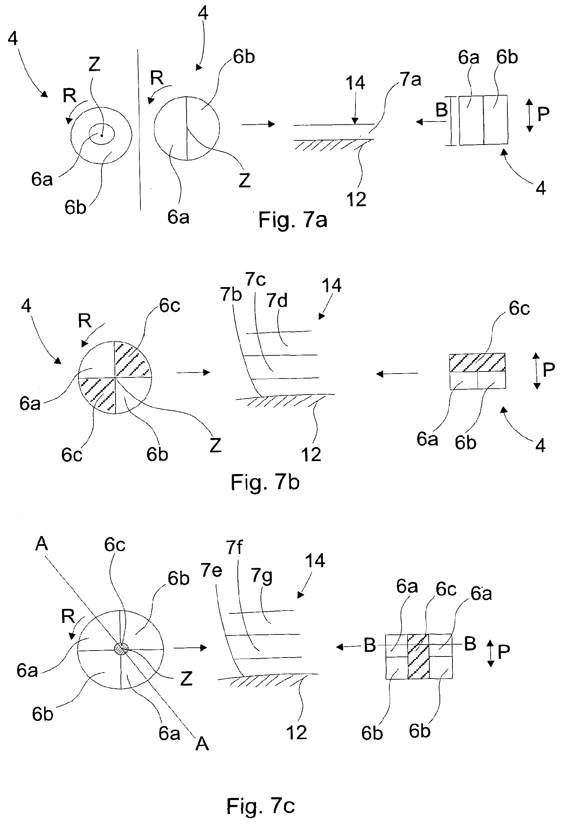

Fig. 7a einen Querschnitt einer beispielhaften abgeschiedenen Feststoffschicht 14 auf dem zu beschichtenden Objekt 12 (Mitte) im Fall der Veränderung des Verlaufes des emittierten Strahles 8 in einer horizontalen Bewegungsrichtung L. Wird beispielsweise eine runde, scheibenartig ausgebildete Probe 4 (linke Aufsicht), welche einen Abschnitt 6a mit der Materialzusammensetzung A und einen Abschnitt 6b mit der Materialzusammensetzung B aufweist, wobei beide Abschnitte beispielsweise als konzentrische Vollkreise oder als Halbkreissegmente vorliegen, in Pfeilrichtung R um eine Achse, welche Senkrecht zu der Oberfläche 16 der Probe 4 ausgebildet ist und welche durch den Mittelpunkt Z der Oberfläche 16 der Probe 4 führt, in Rotation versetzt und erfolgt zeitgleich die Abtragung der Oberfläche 16 durch den horizontal ausgelenkten emittierten Strahl 8, dessen Bewegungsrichtung bevorzugt durch den Mittelpunkt Z der Oberfläche 16 der Probe 4 führt, wird Material A aus Abschnitt 6a und Material B aus Abschnitt 6b in den gasförmigen Zustand 10 überführt. Dieser scheidet sich auf dem zu beschichtenden Objekt 12 als Lage 7a Feststoffschicht 14 mit der Zusammensetzung AₓB_{y}, wobei die Indizes x und y der Summenformel AₓB_{y} jeweils die Anzahl der Atome von Material A und B im Molekül wiedergeben und erfindungsgemäß, bevorzugt von Lage zu Lage, veränderbar sind. Durch die Dauer des Abtragungsprozesses erfolgt u. a. eine Einstellung der Schichtdicke der Feststoffschicht 14. Eine analoge Feststoffschicht 14 kann beispielsweise auch durch eine rechteckige Probe 4 (rechte Aufsicht) erzeugt werden, welche eine Auslenkung in vertikaler Richtung P erfährt und welche ebenfalls einen Abschnitt 6a mit der Materialzusammensetzung A und einen Abschnitt 6b mit der Materialzusammensetzung 6b aufweist, wobei die Abschnitte 6a und 6b rechteckig ausgebildet sind, jeweils der Hälfte der gesamten Probenoberfläche 16 entsprechen und vertikal benachbart zueinander angeordnet sind.

In Fig. 7b ist ein Querschnitt einer multilagigen Feststoffschicht 14 (Mitte) beispielhaft dargestellt. Ausgehend von einer runden, scheibenartigen Probe 4 (linke Aufsicht), deren Oberfläche 16 sich in vier gleichgroße Kreissegmente unterteilt, dargestellt durch die Abschnitte 6a, 6b und 6c, erfolgt bei Rotation der Probe 4 in Pfeilrichtung R um eine Achse, welche Senkrecht zu der Oberfläche 16 der Probe 4 ausgebildet ist und welche durch den Mittelpunkt Z der Oberfläche 16 der Probe 4 führt, unter zeitgleicher horizontaler Veränderung des Verlaufes des emittierten Strahles 8 zunächst eine Abtragung der Oberfläche des Abschnittes 6a, welcher sich aus Material A zusammensetzt und des Abschnittes 6b, welcher sich aus Material B zusammensetzt. Dies bedeutet, dass sowohl Material A als auch Material B in den gasförmigen Zustand 10 übertragen wird und sich mit der Zusammensetzung AₘBₙ, wobei die Indizes m und n der Summenformel AₘBₙ jeweils die Anzahl der Atome von Material A und B im Molekül wiedergeben, als erste Lage 7b auf dem zu beschichtenden Objekt 12 abscheidet. Das Stoffverhältnis zwischen Material A und Material B ist durch das erfindungsgemäße Verfahren einstellbar. Bei weiterer Rotation werden die beiden einander gegenüberliegenden Abschnitte 6c abgetragen und deren Material C in die Gasphase 10 überführt. Dieser gasförmige Zustand 10 des Materiales C lagert sich als zweite Schicht 7c auf der ersten Schicht 7b des zu beschichtenden Objektes 12 ab. Im weiteren Verlauf des Verfahrens wiederholt sich der beschriebene Vorgang, so dass ein Multischichtsystem entsteht, welches sich aus abwechselnden Lagen der variablen Zusammensetzung AₘBₙ und der Zusammensetzung C aufbaut. Eine analoge Schichtabfolge lässt sich aus beispielsweise in Gegenwart einer rechteckigen Probe 4 (rechte Aufsicht) erzeugen, welche eine Bewegung in vertikaler Pfeilrichtung P erfährt, während der Verlauf des emittierten Strahles 8 horizontal verändert wird, und deren Abschnitte 6a, 6b und 6c wie in Fig. 7b dargestellt ausgebildet sind. Die Schichtdicke ist durch das erfindungsgemäße Verfahren einstellbar.

In Fig. 7c ist ein Querschnitt einer Feststoffschicht 14 als komplexes Multischichtsystem dargestellt (Mitte). Erfolgt die Aufteilung der Oberfläche 16 der runden, scheibenartigen Probe 4 (linke Aufsicht) derart, dass die Abschnitte 6a und 6b vier gleich große Kreissegmente bilden, welche alle einen Zentriwinkel von 90° aufweisen und abwechselnd zueinander angeordnet sind, und alle direkt zu dem Abschnitt 6c, welcher als Vollkreis um den Mittelpunkt Z der Oberfläche 16 der Probe 4 ausgebildet ist, benachbart angeordnet sind, so werden bei gleichzeitiger Rotation der Probe 4 und horizontaler Veränderung des Verlaufes des emittierten Strahles 8, zunächst die Abschnitte 6b und 6c abgetragen. Dies bedeutet, dass sowohl Material B aus Abschnitt 6b und Material C aus Abschnitt 6c in den gasförmigen Zustand 10 übergeht und sich als erste Lage 7e mit der Zusammensetzung BₒCₚ auf dem zu beschichtenden Objekt 12 abscheidet, wobei die Indizes o und p der Summenformel BₒCₚ jeweils die Anzahl der Atome von Material B und C im Molekül wiedergeben, welche sich jeweils von Lage zu Lage unterscheiden kann. Bei weiterer Rotation wird das Material A des Abschnittes 6a und das Material C des Abschnittes 6c abgetragen und in den gasförmigen Zustand 10 überführt., welcher sich als zweite Lage 7f mit der Zusammensetzung AᵣCₛ auf der ersten Schicht 7e des zu beschichtenden Objektes 12 abscheidet, wobei die Indizes r und s der Summenformel AᵣCₛ jeweils die Anzahl der Atome von Material A und C im Molekül wiedergeben, welche sich jeweils von Lage zu Lage unterscheiden kann. Bei weiterer Rotation wiederholt sich der beschriebene Vorgang, so dass ein Multischichtsystem mit beliebig vielen Lagen der Zusammensetzungen AᵣCₛ und BₒCₚ entsteht, wobei die Anzahl der Atome von Material A und Material C und von Material B und Material C in den Molekülen AᵣC₈ und BₒCₚ in den Lagen der Feststoffschicht 14 verschieden sein kann. Eine analoge Schichtabfolge der Feststoffschicht 14 kann ebenso mit einer rechteckigen Probe 4 (rechte Aufsicht) erzeugt werden, welche sich in vertikaler Bewegungsrichtung P gleichzeitig zu dem horizontal ausgelenkten Strahl 8 bewegt, erzeugt werden. Die rechteckige Probe 4 weist drei unterschiedliche Materialabschnitte 6a, 6b und 6c auf, wobei die rechteckigen Abschnitte 6a und 6b zueinander horizontal benachbart angeordnet sind und jeweils ein Sechstel der Probenoberfläche 16 einnehmen. Der Abschnitt 6c ist direkt benachbart zu beiden Abschnitten 6a und 6b vertikal über eine gesamte Breite B der rechteckigen Probe 4 angeordnet und entspricht einem Drittel der Probenoberfläche 16. Das letzte Drittel der Probenoberfläche 16 wird durch zwei gleichgroße, rechteckige Abschnitte 6a und 6b gebildet, welche horizontal zueinander angeordnet sind. Hier werden zunächst die Abschnitte 6a und 6c abgetragen und in den gasförmigen Zustand 10 überführt, welcher sich als erste Schicht 7e auf dem zu beschichtenden Objekt 12 abscheidet. Im weiteren Bewegungsverlauf werden die Abschnitte 6b und 6c abgetragen, welche sich als zweite Schicht 7f auf der ersten Schicht 7e auf dem zu beschichtenden Objekt 12 abscheiden. Die Einstellung der Schichtdicken der einzelnen Lagen 7 bzw. die Schichtabfolge der gesamten Feststoffschicht 14 erfolgt beispielsweise durch die Bewegungsgeschwindigkeit des emittierten Strahles 8 oder auch durch die Bewegungsgeschwindigkeit der Probe 4, sowie durch den vom Strahl getroffenen Probenbereich. Verhältnisse der Materialien in den abgeschiedenen Mono- und/oder Multifeststoffschichten 14 können weiterhin auch durch die Geometrie der Abschnitte 6 oder durch die Länge und Position des Bewegungspfades X des emittierten Strahles 8 auf der Oberfläche der Probe 4 eingestellt werden.

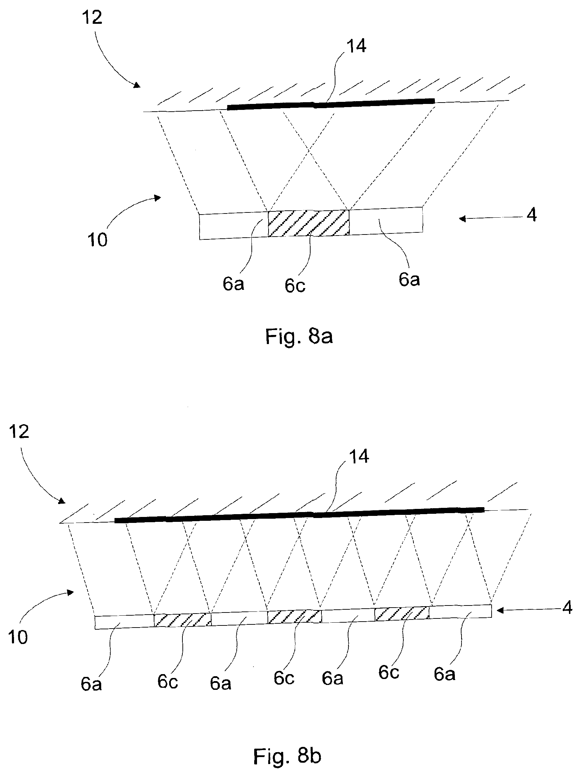

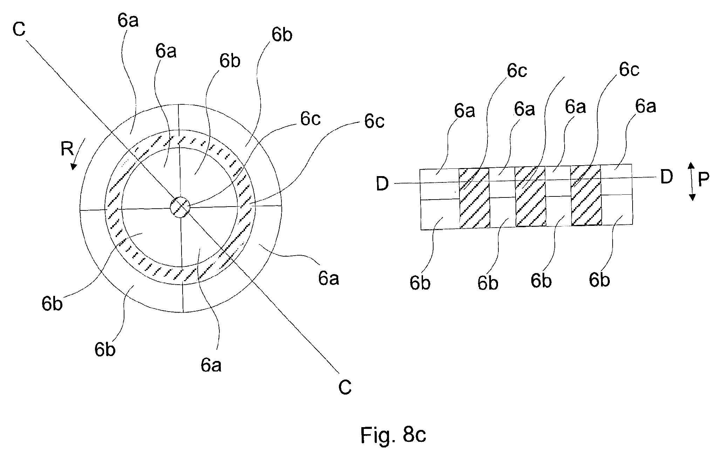

Fig.8a zeigt einen schematischen Querschnitt einer Probe 4 entlang der Linie A--A einer runden Probe 4 in Fig. 7c (linke Aufsicht) bzw. entlang der Linie B--B einer rechteckigen Probe 4 (rechte Aufsicht) während der Überführung des Probenmaterials in den gasförmigen Zustand 10, welcher sich bevorzugt kegelartig ausbreitet und als Feststoffschicht 14 auf dem zu beschichtenden Objekt 12 abscheidet. Die Veränderung des Verlaufes des emittierten Strahles 8 erfolgt hier in horizontaler Richtung (nicht gezeigt). Die in den Fig. 8a und 8b beispielhaften Querschnittsdarstellungen zeigen, dass die Größe der Feststoffschicht 14 in ihrer Länge bzw. in ihrem Durchmesser von der Größe der Probe 4 bedingt ist, d. h. je größer die Oberfläche 16 der Probe 4 ausgebildet ist, desto größere Flächen können auf dem zu beschichtenden Objekt 12 beschichtet werden. Das Verfahren ist somit an die Objektgröße 12 anpassbar. Fig. 8b zeigt einen schematischen Querschnitt einer Probe 4 entlang der Linie C--C einer runden Probe 4 in Fig. 8c (linke Aufsicht) bzw. entlang der Linie D--D einer rechteckigen Probe 4 (rechte Aufsicht) in Fig. 8c während der Überführung des Probenmaterials in den gasförmigen Zustand 10, welcher sich bevorzugt kegelartig ausbreitet und als Feststoffschicht 14 auf dem zu beschichtenden Objekt 12 abscheidet, wobei der Verlauf des emittierten Strahles 8 horizontal erfolgt. Durch die größere Probenoberfläche 16, welche zudem auch in unterschiedliche Materialabschnitte 6 unterteilbar ist, ist eine in Materialzusammensetzung und Dicke einheitlich aufgebaute Feststoffschicht 14 für große Objekte 12 möglich. In Fig. 8a und 8b ist das zu beschichtenden Objekt der Einfachkeit wegen direkt gegenüber der Probenoberfläche 16 angeordnet. Die Anordnung der Probe 4 und dem zu beschichtenden Objekt 12 zueinander kann jedoch auch in beliebig einstellbaren Winkeln erfolgen.

Des weiteren muss berücksichtigt werden, dass die Geschwindigkeit, mit der sich die Probe 4 bewegt, sowie die Geschwindigkeit der Veränderung des Verlaufes des Strahles 8 während des Schrittes der Abtragung einerseits gleich, aber auch verschieden sein können. So ist beispielsweise möglich, dass sich die Probe 4 im Verhältnis viel schneller rotativ bewegt, als die Veränderung des Verlaufes des Strahles 8 erfolgt. Ist dies der Fall, nimmt der Bewegungspfad X an der Oberfläche 16 der Probe 4 die Form einer Spirale an. Durch die Variabilität der beiden Bewegungsgeschwindigkeiten der Probe 4 und des Strahles 8 kann der Bewegungspfad X des Strahles an der Oberfläche 16 der Probe 4 beeinflusst werden.

Die Anmelderin behält sich vor, sämtliche in den Anmeldungsunterlagen offenbarte Merkmale als erfindungswesentlich zu beanspruchen, sofern sie einzeln oder in Kombination neu gegenüber dem Stand der Technik sind.

### Bezugszeichenliste

- 2: Strahlungserzeugungsquelle
- 4: Probe
- 6: Abschnitt der Probe
- 6a: Abschnitt der Probe mit Material A
- 6b: Abschnitt der Probe mit Material B
- 6c: Abschnitt der Probe mit Material C
- 6d: Abschnitt der. Probe mit Material D
- 7: Lage der Feststoffschicht
- 8: Strahl
- 10: gasförmiger Zustand
- 12: zu beschichtendes Objekt
- 14: Feststoffschicht
- 16: Oberfläche der Probe
- 18b: räumlicher Neigungswinkel der Probe
- 23: Vorrichtung
- 24: Ausrichtungsveränderungseinrichtung
- 26: Vakuumkammer
- 28: erste externe Antriebseinrichtung
- 30: Pumpeinrichtung
- 32: zweite externe Antriebseinrichtung
- 34: Maske
- 36: externer Zugang
- 38: Öffnung der Maske
- 40: optisches Fenster
- 42: Probenträger
- 43: Probenträgerhalter
- 44: Stempel
- P: vertikale Bewegungsrichtung der Probe
- L: vertikale Bewegungsrichtung des Strahles
- F: Bewegungsrichtung des Stempels
- X: Bewegungspfad des Strahles an der Oberfläche der Probe
- Z: Mittelpunkt der Oberfläche der Probe
- R: rotative Bewegung der Probe
- B: Breite der eckigen Probe

## Patentansprüche

1. Verfahren zum Aufbringung von Feststoffschichten (14) auf ein zu beschichtendes Objekt (12) mittels mindestens einer Strahlungserzeugungsquelle (2), zumindest umfassend den Schritt des Abtragens einer Probe (4) im festen Zustand in zumindest teilweise verschiedenen Abschnitten (6) aus unterschiedlichen Materialien mit mindestens einem von der Strahlungserzeugungsquelle (2) emittierten Strahl (8) zum zumindest teilweise Überführen der Probe (4) in einen gasförmigen Zustand (10), der sich auf dem zu beschichtenden Objekt (12) zumindest teilweise abscheidet, um eine Feststoffschicht (14) zu bilden, wobei zeitgleich ein Verlauf des emittierten Strahles (8) während des Schrittes der Abtragung in seiner Ausrichtung verändert wird und die Probe (4) bewegt wird,
**dadurch gekennzeichnet, dass**
die Veränderungsbewegung des Verlaufes des emittierten Strahles (8) in seiner Ausrichtung abhängig von der Bewegung der Probe (4) erfolgt, wobei die Veränderungsbewegung, welche die Ausrichtung des Verlaufes des emittierten Strahles (8) bedingt, und die Bewegung der Probe (4) durch ihre Bewegungsgeschwindigkeit miteinander gekoppelt sind.

2. Verfahren nach Anspruch 1,
**dadurch gekennzeichnet, dass**
die Veränderung des Verlaufes des Strahles (8) in seiner Ausrichtung derart erfolgt, dass sich eine Linearbewegung des Strahles (8) an einer Oberfläche (16) der Probe (4), die den Verlauf des emittierten Strahles (8) kreuzt, ergibt.

3. Verfahren nach Ansprüchen 1 - 2,
**dadurch gekennzeichnet, dass**
der Strahl (8) unter einem vorbestimmbaren Winkel auf die Oberfläche (16) der Probe (4), die den Verlauf des emittierten Strahles (8) kreuzt, auftrifft, wobei die Probe (8) zeitgleich um eine Achse rotiert.

4. Verfahren nach einem der vorangegangenen Ansprüche,
**dadurch gekennzeichnet, dass**
der Strahl unter einem vorbestimmbaren Winkel auf die Oberfläche (16) der Probe (4), die den Verlauf des emittierten Strahles (8) kreuzt, auftrifft, wobei eine Position der Probe (4) zeitgleich in eine Richtung verändert wird.

5. Verfahren nach einem der vorangegangenen Ansprüche,
**dadurch gekennzeichnet, dass**
homogene Elemente, metallische und/oder nichtmetallische Zusammensetzungen, wie Oxide, Nitride oder Halogenide, als Materialien für die Abschnitte (6) der Probe (4) verwendet werden.

6. Verfahren nach einem der vorangegangenen Ansprüche,
**dadurch gekennzeichnet, dass**
die verschiedenen Abschnitte (6) der Probe (4) Schichten und/oder nebeneinander auf der Oberfläche liegende Bereiche darstellen.

7. Verfahren nach einem der vorangegangenen Ansprüche,
**dadurch gekennzeichnet, dass**
die verschiedenen Abschnitte (6) der Probe (4) während des Abtragungsschrittes senkrecht zur Oberfläche (16) der Probe (4) bewegt werden.

8. Vorrichtung zum Aufbringen von Feststoffschichten (14) auf ein zu beschichtendes Objekt (12) mit einer Strahlerzeugungsquelle (2), einer Ausrichtungsveränderungseinrichtung (24) zur Veränderung des Verlaufes des emittierten Strahles (8) und einer Vakuumkammer (26) mit einer darin anordbaren Probe (4), welche zumindest teilweise verschiedene Abschnitte (6) aus unterschiedlichen Materialien aufweist, mittels einer externen Antriebseinrichtung (28) bewegbar ist und mit dem Strahl (8) in ihrer Oberfläche (16) abtragbar ist, wobei der Verlauf des Strahles (8) in seiner Ausrichtung bewegbar ist und zeitgleich die Probe (4) bewegbar ist,
**dadurch gekennzeichnet, dass**
die Veränderungsbewegung des Verlaufes des emittierten Strahles (8) in seiner Ausrichtung abhängig von der Bewegung der Probe (4) ist, wobei die Veränderungsbewegung, welche die Ausrichtung des Verlaufes des emittierten Strahles (8) bedingt, und die Bewegung der Probe (4) durch ihre Bewegungsgeschwindigkeit miteinander koppelbar sind.

9. Vorrichtung nach Anspruch 8,
**dadurch gekennzeichnet, dass**
die Ausrichtungsveränderungseinrichtung (24) zur Veränderung des Verlaufes des emittiertes Strahles (8) zumindest einen Spiegel und / oder zumindest einen Strahlaufweiter und / oder mindestens eine Fokussiereinrichtung aufweist.

10. Vorrichtung nach den Ansprüchen 8 und 9,
**dadurch gekennzeichnet, dass**
die verschiedenen Abschnitte (6) der Probe (4) als Schichten und/oder als nebeneinander liegende Bereiche angeordnet sind.

11. Vorrichtung nach den Ansprüchen 9 bis 10,
**dadurch gekennzeichnet, dass**
die geometrische Ausgestaltung der Probe (4) ein dreidimensionaler Körper ist.

12. Vorrichtung nach den Ansprüchen 9 bis 11,
**dadurch gekennzeichnet, dass**
das zu beschichtende Objekt (12) mittels einer zweiten externen Antriebseinrichtung (32) um eine zentrale Achse rotierbar ist und/ oder in zumindest einer Position senkrecht und/oder parallel zu einer Wand der Vakuumkammer (26) bewegbar angeordnet ist.

13. Vorrichtung nach den Ansprüchen 9 bis 12,
**dadurch gekennzeichnet, dass**
zumindest eine Maske (34) zwischen der Probe (4) und dem zu beschichtenden Objekt (12) stationär und/oder bewegbar angeordnet ist.

14. Vorrichtung nach Anspruch 9,
**dadurch gekennzeichnet, dass**
die Vakuumkammer (26) über zumindest einen zusätzlichen externen Zugang (36) verfügt, durch welchen beispielsweise Gas oder Gasgemische in die Vakuumkammer (26) einführbar sind, um Feststoffschichten (14) auf dem zu beschichtenden Objekt (12) zu erzeugen.

## Claims

1. Method for applying solid layers (14) to an object (12) to be coated by means of at least one radiation generation source (2), at least comprising the step of removing a sample (4) in the solid state in portions (6), which are different at least in part and consist of different materials, by means of at least one beam (8), which is emitted by the radiation generation source (2), in order to convert the sample (4), at least in part, into a gaseous state (10) which is deposited at least in part on the object (12) to be coated in order to form a solid layer (14), the orientation of a course of the emitted beam (8) being simultaneously altered during the removal step and the sample (4) being moved, **characterised in that** the movement altering the orientation of the course of the emitted beam (8) takes place depending on the movement of the sample (4), the alteration movement, which determines the orientation of the course of the emitted beam (8), and the movement of the sample (4) being linked to one another by their movement speed.

2. Method according to claim 1, **characterised in that** the orientation of the course of the beam (8) is altered in such a way that a linear movement of the beam (8) results on a surface (16) of the sample (4) which crosses the course of the emitted beam (8).

3. Method according to claims 1 and 2, **characterised in that** the beam (8) hits, at a predeterminable angle, the surface (16) of the sample (4) which crosses the course of the emitted beam (8), the sample (8) simultaneously rotating about an axis.

4. Method according to any of the preceding claims, **characterised in that** the beam hits, at a predeterminable angle, the surface (16) of the sample (4) which crosses the course of the emitted beam (8), a position of the sample (4) simultaneously being altered in one direction.

5. Method according to one of the preceding claims, **characterised in that** homogeneous elements, metal and/or non-metal compositions, such as oxides, nitrides or halides, are used as materials for the portions (6) of the sample (4).

6. Method according to any of the preceding claims, **characterised in that** the different portions (6) of the sample (4) are layers and/or regions located side by side on the surface.

7. Method according to any of the preceding claims, **characterised in that** the different portions (6) of the sample (4) are moved perpendicularly to the surface (16) of the sample (4) during the removal step.

8. Apparatus for applying solid layers (14) to an object (12) to be coated, comprising a radiation generation source (2), an orientation alteration device (24) for altering the course of the emitted beam (8) and a vacuum chamber (26) having a sample (4) arrangeable therein which comprises portions (6) which are different at least in part and consist of different materials, which sample is movable by means of an external drive device (28) and the surface (16) thereof can be removed by the beam (8), the orientation of the course of the beam (8) being movable and the sample (4) being simultaneously movable, **characterised in that** the movement altering the orientation of the course of the emitted beam (8) is dependent on the movement of the sample (4), the alteration movement, which determines the orientation of the course of the emitted beam (8), and the movement of the sample (4) being linkable to one another by their movement speed.

9. Apparatus according to claim 8, **characterised in that** the orientation alteration device (24) for altering the course of the emitted beam (8) comprises at least one mirror and/or at least one beam expander and/or at least one focusing device.

10. Apparatus according to claims 8 and 9, **characterised in that** the different portions (6) of the sample (4) are arranged as layers and/or as regions located side by side.

11. Apparatus according to claims 9 and 10, **characterised in that** the geometric configuration of the sample (4) is a three-dimensional body.

12. Apparatus according to claims 9 to 11, **characterised in that** the object (12) to be coated can be rotated about a central axis by means of a second external drive device (32) and/or is arranged in at least one position so as to be movable perpendicularly and/or in parallel with a wall of the vacuum chamber (26).

13. Apparatus according to claims 9 to 12, **characterised in that** at least one mask (34) is arranged in a stationary and/or movable manner between the sample (4) and the object (12) to be coated.

14. Apparatus according to claim 9, **characterised in that** the vacuum chamber (26) comprises at least one additional external inlet (36), through which for example gas or gas mixtures can be introduced into the vacuum chamber (26) in order to produce solid layers (14) on the object (12) to be coated.

## Revendications

1. Procédé permettant l'application de couches solides (14) sur un objet (12) à revêtir au moyen d'au moins une source de production de rayonnement (2), comportant au moins l'étape d'ablation d'un échantillon (4) à l'état solide dans des portions (6) au moins partiellement distinctes, qui sont réalisées dans des matériaux différents, par au moins un faisceau (8) émis par la source de production de rayonnement (2) pour transformer au moins partiellement l'échantillon (4) en un état gazeux (10), qui se dépose au moins partiellement sur l'objet (12) à revêtir, afin de former une couche solide (14),
l'orientation d'une trajectoire du faisceau (8) émis étant amenée à varier pendant l'étape d'ablation de matière et l'échantillon (4) étant déplacé simultanément, **caractérisé en ce que**
le mouvement de variation de l'orientation de la trajectoire du faisceau (8) émis est en fonction du déplacement de l'échantillon (4), le mouvement de variation, qui conditionne l'orientation de la trajectoire du faisceau (8) émis, et le déplacement de l'échantillon (4) étant couplés entre eux par leur vitesse de mouvement.

2. Procédé selon la revendication 1, **caractérisé en ce que** la variation de l'orientation de la trajectoire du faisceau (8) étant effectuée de telle sorte qu'il en résulte un mouvement linéaire du faisceau (8) sur une surface (16) de l'échantillon (4), qui croise la trajectoire du faisceau (8) émis.

3. Procédé selon les revendications 1 et 2, **caractérisé en ce que** le faisceau (8) est projeté selon un angle prédéfini sur la surface (16) de l'échantillon (4), qui croise la trajectoire du faisceau (8) émis, l'échantillon (4) tournant en même temps autour d'un axe.

4. Procédé selon l'une quelconque des revendications précédentes, **caractérisé en ce que** le faisceau est projeté selon un angle prédéfini sur la surface (16) de l'échantillon (4), qui croise la trajectoire du faisceau (8) émis, une position de l'échantillon (4) étant modifiée en même temps dans une direction.

5. Procédé selon l'une quelconque des revendications précédentes, **caractérisé en ce que** des éléments homogènes, des composés métalliques et/ou non métalliques, tels que des oxydes, des nitrures ou des halogénures, sont utilisés comme des matériaux pour les portions (6) de l'échantillon (4).

6. Procédé selon l'une quelconque des revendications précédentes, **caractérisé en ce que** les différentes portions (6) de l'échantillon (4) constituent des couches et/ou des zones juxtaposées sur la surface.

7. Procédé selon l'une quelconque des revendications précédentes, **caractérisé en ce que** les différentes portions (6) de l'échantillon (4) sont déplacées perpendiculairement à la surface (16) de l'échantillon (4) pendant l'étape d'ablation de matière.

8. Dispositif permettant de déposer des couches solides (14) sur un objet (12) à revêtir, comportant une source de production de rayonnement (2), un dispositif de variation de l'orientation (24) pour faire varier la trajectoire du faisceau (8) émis, et une chambre sous vide (26) avec un échantillon (4), qui peut être disposé dans celle-ci, qui comporte des portions (6) au moins partiellement distinctes en matériaux différents, qui peut être déplacé au moyen d'un dispositif d'entraînement (28) externe et qui peut être ablaté sur sa surface (16) au moyen du faisceau (8),
l'orientation de la trajectoire du faisceau (8) étant déplaçable et l'échantillon (4) pouvant être déplacé en même temps,
**caractérisé en ce que**
le mouvement de variation de l'orientation de la trajectoire du faisceau (8) émis est fonction du déplacement de l'échantillon (4), le mouvement de variation, qui conditionne l'orientation de la trajectoire du faisceau (8) émis, et le déplacement de l'échantillon (4) pouvant être couplés entre eux par leur vitesse de mouvement.

9. Dispositif selon la revendication 8, **caractérisé en ce que** le dispositif de variation de l'orientation (24) destiné à faire varier la trajectoire du faisceau (8) émis comporte au moins un miroir et/ou au moins un élargisseur de faisceau et/ou au moins un dispositif de focalisation.

10. Dispositif selon les revendications 8 et 9, **caractérisé en ce que** les différentes portions (6) de l'échantillon (4) sont disposées sous forme de couches et/ou sous forme de zones juxtaposées.

11. Dispositif selon les revendications 9 et 10, **caractérisé en ce que** la forme géométrique de l'échantillon (4) est un corps tridimensionnel.

12. Dispositif selon les revendications 9 à 11, **caractérisé en ce que** l'objet (12) à revêtir est apte à tourner autour d'un axe central au moyen d'un deuxième dispositif d'entraînement (32) externe, et/ou est disposé dans au moins une position de manière mobile perpendiculairement et/ou parallèlement à une paroi de la chambre sous vide (26).

13. Dispositif selon les revendications 9 à 12, **caractérisé en ce qu'**au moins un masque (34) est disposé de manière stationnaire et/ou mobile entre l'échantillon (4) et l'objet (12) à revêtir.

14. Dispositif selon la revendication 9, **caractérisé en ce que** la chambre sous vide (26) comporte au moins un accès (36) extérieur supplémentaire, à travers lequel il est possible d'injecter le gaz ou des mélanges de gaz dans la chambre sous vide (26), afin de réaliser des couches solides (14) sur l'objet (12) à revêtir.
